# FASCICULE DE BREVET EUROPEEN

(11) **EP 0 501 872 B1**
(45) Date de publication et mention de la délivrance du brevet: **21.08.1996**
(21) Numéro de dépôt: 92400482.3
(22) Date de dépôt: 25.02.1992
(51) Int. Cl.: H04B 10/16, H01S 3/133

(54) **Dispositif à rétroaction positive pour le traitement d'un signal optique**
Vorrichtung mit positiver Rückkopplung zur optischen Signalverarbeitung
Positive feedback device for optical signal processing

(30) Priorité: 27.02.1991 FR 9102351
(43) Date de publication de la demande: 02.09.1992
(73) Titulaire: ALCATEL N.V., NL-1077 XX Amsterdam (NL)
(72) Inventeur: Chesnoy, José, F-75014 Paris (FR); Gabriagues, Jean-Michel, F-91530 Le Val Saint Germain (FR); Leclerc, Denis, F-92340 Bourg La Reine (FR)
(74) Mandataire: Bourely, Paul

(56) Documents cités:
- EP-A- 0 395 277
- FR-A- 2 239 063
- PATENT ABSTRACTS OF JAPAN vol. 9, no. 310 (E-364)(2033) 6 Décembre 1985 & JP-A-60145690
- PATENT ABSTRACTS OF JAPAN vol. 8, no. 133 (P-281)(1570) 16 Avril 1982 & JP-A-59036223
- PATENT ABSTRACTS OF JAPAN vol. 8, no. 101 (P-273)(1538) 12 Mai 1984 & JP-A-59012421

## Description

L'optoélectronique prend une place grandissante dans les systèmes de communication à fibres optiques. Pourtant, la mise en forme ou plus généralement le traitement des signaux optiques n'est jusqu'ici proposée de manière réaliste qu'en convertissant le signal optique en signal électrique par un photodétecteur. Ce signal électrique est ensuite traité par un système électronique puis reconverti en signal optique à l'aide d'un laser semiconducteur. Un tel traitement est en particulier réalisé dans les régénérateurs optiques. La nécessité pour de tels dispositifs de traitement de comporter des éléments optiques (lasers, détecteurs) associés à des éléments électroniques (transistors) limite les possibilités d'intégration de ces éléments sur un substrat commun constitué par exemple de phosphure d'indium. D'autre part, des limitations de la bande passante peuvent être dues aux amplificateurs électroniques utilisés.

Des dispositifs à rétroaction positive sont connues de l'état de la technique, par exemple Abstract of JP-A-59 036 223, mais les caractéristiques de gain de boucle ne sont pas bien définies.

La présente invention vise les buts suivants :
- Réaliser de manière simple un dispositif à rétroaction positive pour le traitement d'un signal optique.
- Faciliter l'intégration des éléments d'un tel dispositif sur un nombre diminué de substrats.
- Eviter autant que possible l'utilisation de composants électroniques devant fonctionner à des fréquences élevées.
- Eviter les limitations de bande passante dues à de tels composants.

Dans ces buts, elle a pour objet un dispositif à rétroaction positive pour le traitement d'un signal optique suivant la revendication 1.

A l'aide des figures schématiques ci-jointes, on va décrire ci-après comment la présente invention peut être mise en oeuvre, étant entendu que les éléments et dispositions mentionnés et représentés ne le sont qu'à titre d'exemples non limitatifs.

La figure 1 représente une vue en coupe longitudinale d'un premier dispositif incluant un oscillateur laser et réalisant une mise en oeuvre de la présente invention.

La figure 2 représente une vue d'une plaquette semiconductrice de cet oscillateur en coupe par un plan horizontal passant par une couche de guidage de lumière de ce laser.

Les figures 3 à 6 représentent des diagrammes de variation de la puissance optique émise par cette plaquette semiconductrice en fonction de l'intensité d'un courant d'alimentation injecté dans un amplificateur de cette plaquette, pour quatre valeurs de l'intensité d'un courant de commande d'absorption injecté dans un absorbeur de cette plaquette.

La figure 7 représente des diagrammes de variation d'un signal de sortie en fonction d'un signal d'entrée de ce dispositif pour trois valeurs d'un gain moyen d'une boucle de rétroaction formée par ce dispositif.

La figure 8 représente une vue d'un deuxième dispositif de mise en oeuvre de la présente invention.

Les deux dispositifs donnés en exemple sont des dispositifs de traitement d'un signal optique. Le premier d'entre eux inclut un oscillateur laser semiconducteur à absorbeur saturable. On va d'abord décrire cet oscillateur de manière générale, des informations sur un oscillateur analogue pouvant être trouvées dans un document Lasher (G.J. LASHER. "Analysis of a proposed bistable injection laser", Solid-state Electronics, Pergamon press 1964, vol 7, p707).

Cet oscillateur laser comporte un empilement des couches suivantes, ces couches se succédant selon une direction verticale Z définie par rapport à cet empilement :
- une couche d'électrode inférieure 2 sous une face inférieure 3 d'une plaquette semiconductrice 4,
- une couche de confinement inférieure 6 appartenant à cette plaquette semiconductrice et présentant un premier type de conductivité électrique et un indice de réfraction,
- une couche de guidage de lumière 8 comportant un guide de lumière S1, S2, S3 constitué au moins partiellement d'un matériau semiconducteur en continuité cristalline avec cette couche de confinement inférieure et présentant un indice de réfraction supérieur à celui de cette couche de confinement inférieure pour permettre de réaliser un confinement optique vertical dans cette couche de guidage,
- une couche de confinement supérieure 10 appartenant à ladite plaquette semiconductrice et présentant une continuité cristalline avec ce guide de lumière, un deuxième type de conductivité électrique opposé au premier, et un indice de réfraction inférieur à celui de ce guide de lumière pour réaliser ledit confinement optique vertical,
- et une couche d'électrodes supérieures 12 sur une face supérieure 14 de ladite plaquette semiconductrice.

Le guide de lumière S1, S2, S3 s'étend selon une direction longitudinale X dans la couche de guidage de lumière entre deux zones de confinement latérales 16, 18. Les indices de réfraction de ces deux zones sont choisis inférieurs à celui de ce guide pour réaliser un confinement optique transversal confinant une lumière dans ce guide entre ces deux zones de confinement latérales. Ce guide comporte une succession de sections selon la direction longitudinale d'arrière en avant : Une première section est un amplificateur de lumière S1. Une deuxième section est un absorbeur saturable S2 et constitue avec cet amplificateur un ensemble actif S1, S2. Cet ensemble actif est constitué d'un matériau actif semiconducteur choisi pour agir sur une lumière d'émission qui se propage avec une longueur d'onde d'émission selon cette direction longitudinale. Ce matériau est apte à être traversé par des courants électriques passant entre les deux couches de confinement inférieure et supérieure, l'intensité de tels courants étant comptée algébriquement dans un sens direct par rapport aux types de conductivité de ces deux couches. Ce matériau amplifie cette lumière dans cet amplificateur lorsqu'un courant électrique traversant cet amplificateur présente une densité de courant supérieure à un seuil d'amplification. Ce courant constitue alors un courant d'alimentation I1. Ce matériau absorbe cette lumière dans cet absorbeur lorsqu'un courant électrique traversant cet absorbeur présente une densité de courant inférieure à ce seuil d'amplification. Ce courant constitue alors un courant de commande d'absorbance I2. Cet absorbeur absorbe une énergie nouvelle de cette lumière seulement dans la mesure où l'énergie de cette lumière qu'il a déjà absorbée et accumulée pendant une période de conservation d'énergie est inférieure à son absorbance, cette période de conservation d'énergie ayant une durée limitée et précédant et incluant l'instant où cet absorbeur reçoit cette énergie nouvelle. Cette absorbance est commandée par ce courant de commande.

La couche d'électrodes supérieures comporte:
- une électrode d'alimentation E1 localisée pour transmettre un dit courant d'alimentation I1 vers la couche d'électrode inférieure 2 à travers l'amplificateur S1,
- et une électrode de commande d'absorbance E2 localisée pour transmettre un dit courant de commande d'absorbance I2 vers la couche d'électrode inférieure à travers l'absorbeur S2.

Ce laser comporte encore :
- une source d'alimentation 20 pour fournir ce courant d'alimentation à cette électrode d'alimentation,
- et une source de commande d'absorbance 22, 23, 24, 26 pour fournir ce courant de commande d'absorption à l'électrode de commande E2.

Des moyens de réflexion de lumière 27, 28 sont disposés de part et d'autre longitudinalement de l'ensemble actif S1, S2 pour que la plaquette semiconductrice 4 constitue un oscillateur laser émettant ladite lumière d'émission. Ils sont constitués, dans le dispositif donné en exemple, par les faces arrière 27 et avant 28 de la plaquette 4, ces faces étant partiellement réfléchissantes pour constituer un résonateur Fabry-Perot. Ils pourraient aussi être constitués par des miroirs externes ou par un réflecteur de Bragg distribué interne à cette plaquette.

De manière habituelle les électrodes d'alimentation E1 et de commande d'absorbance E2 présentent la forme de rubans ayant, selon une direction transversale Y, des longueurs supérieures à la largeur du guide de lumière S1, S2, S3, des moyens de confinement électrique latéral étant prévus pour empêcher, au moins partiellement lesdits courants d'alimentation I1 et de commande d'absorption I2 de passer à travers lesdites zones de confinement latérales 16, 18. Ces moyens de confinement électrique peuvent être notamment constitués par une composition ou structure interne convenable de ces zones de confinement.

Selon une disposition dont des avantages apparaîtront ci-après le guide de lumière S1, S2, S3 comporte, au sein de la plaquette semiconductrice 4 et à l'avant de l'absorbeur S2, une troisième section constituée d'un matériau passif choisi pour transmettre ladite lumière d'émission sans agir sensiblement ni sur son intensité ni sur sa vitesse de propagation. Cette section constitue une section passive S3.

Ce guide peut être simple, chacune de ses sections étant en continuité géométrique avec les précédentes. Les couplages entre sections sont alors longitudinaux. Ce guide peut aussi être composite, par exemple constitué de deux sous couches superposées. Le couplage entre l'absorbeur et la section passive peut alors être un couplage vertical couplant mutuellement ces deux couches.

De plus ce guide peut comporter d'autres sections qui peuvent être, par exemple, une section de décalage de phase et une section d'accord de fréquence telles que décrites dans un document KONDO pour réaliser un laser à fréquence commandée (K. KONDO; H.NOBUHARA; S.YAMAKOSHI. "Giga-bit operation of wavelength conversion laser". Paper 13D-9, Conférence "Photonic Switching 90", 12-14 Avril 1990, KOBE, Japon)

Par ailleurs certains composants non représentés pourraient être intégrés à la plaquette semiconductrice. Tel pourrait être, notamment le cas d'une photodiode appartenant à la source de commande d'absorbance ou d'un amplificateur de lumière supplémentaire externe à la cavité résonante de l'oscillateur laser.

Selon une autre disposition avantageuse qui est rendue possible par la présence de la section passive S3, l'électrode de commande d'absorbance E2 s'étend au moins partiellement au-dessus de cette section. Cette disposition permet à cette électrode de présenter, selon la direction longitudinale, une dimension supérieure à la longueur de l'absorbeur. Lorsque, ce qui est souvent le cas, cette longueur est plus petite que la largeur d'un ruban métallique que l'on sait former facilement pour réaliser cette électrode, cette disposition permet de réaliser facilement cette électrode. Elle permet en même temps de réaliser un absorbeur plus court que la largeur de cette électrode, ceci permettant au laser de répondre rapidement aux variations du courant de commande d'absorbance.

La plaquette 4 présente une face avant clivée 28 formant une extrémité avant de la section passive S3. Cette face de la plaquette est formée, comme sa face arrière 27, par une opération de clivage habituelle dont on sait qu'elle entraîne une imprécision sur la position de la face ainsi réalisée. Grâce à la présence de cette section cette imprécision est acceptable parce qu'elle affecte seulement la longueur de cette section alors qu'en l'absence de cette section passive, cette imprécision affecterait la longueur de l'absorbeur, ce qui empecherait d'obtenir de manière reproductible une grande vitesse de réponse du laser au courant de commande d'absorbance.

Selon une autre disposition avantageuse l'amplificateur S1 et l'absorbeur S2 sont connectés optiquement à un composant optique 26 par l'intermédiaire de la section passive S3. Cette disposition facilite la réalisation d'un circuit optique incluant la plaquette 4 et ce composant. Ce dernier est par exemple une photodiode 26 qui constitue un récepteur de lumière et fait partie de la source de commande d'absorbance 22, 23, 24, 26.

Des canaux d'isolation électrique sont formés dans la plaquette semiconductrice 4 à partir de sa face supérieure 14. Un canal d'isolation arrière C1 est localisé longitudinalement entre l'électrode d'alimentation E1 et l'absorbeur S2. Un canal d'isolation avant C2 est localisé longitudinalement au voisinage du bord avant de l'électrode de commande E2 et il constitue un obstacle au courant électrique sur des trajets allant de l'électrode de commande d'absorbance E2 à la couche d'électrode inférieure 2 en passant à travers la section passive S3. La présence d'un tel obstacle permet de réaliser une commande efficace en utilisant une source de commande d'absorbance fournissant un courant de relativement faible intensité, ceci parce qu'une fraction efficace relativement importante de ce courant passe à travers l'absorbeur alors que la condition à remplir relativement à ce courant pour réaliser une commande efficace est que cette fraction efficace ait une intensité suffisante.

L'oscillateur laser dont diverses dispositions viennent d'être décrites émet ladite lumière d'émission sous la forme d'un faisceau P3, en réponse à un signal d'entrée de nature électrique tel que ce courant de commande d'absorbance I2. Par contre le dispositif de traitement de signal optique qui inclut cet oscillateur émet cette lumière en réponse à un signal d'entrée de nature optique. Ce signal d'entrée est constitué par un faisceau lumineux P1 reçu par la photodiode 26 qui constitue un récepteur de lumière inclus dans la source de commande d'absorbance. Ce faisceau commande un courant qui traverse cette photodiode et qui constitue, pour partie, le courant de commande d'absorbance I2. Il commande ainsi un signal de sortie de nature optique constitué par le faisceau P3.

On va maintenant décrire de manière générale certaines dispositions qui sont adoptées dans les dispositifs de traitement selon la présente invention et qui leur sont communes, quant aux fonctions indiquées, avec un dispositif de traitement antérieur. Ce dispositif antérieur est décrit dans un document OKUMURA (K. OKUMURA, Y.OGAWA, H.ITO, AND H.INABA Opt.Letters, 9, p. 519 (1984)).

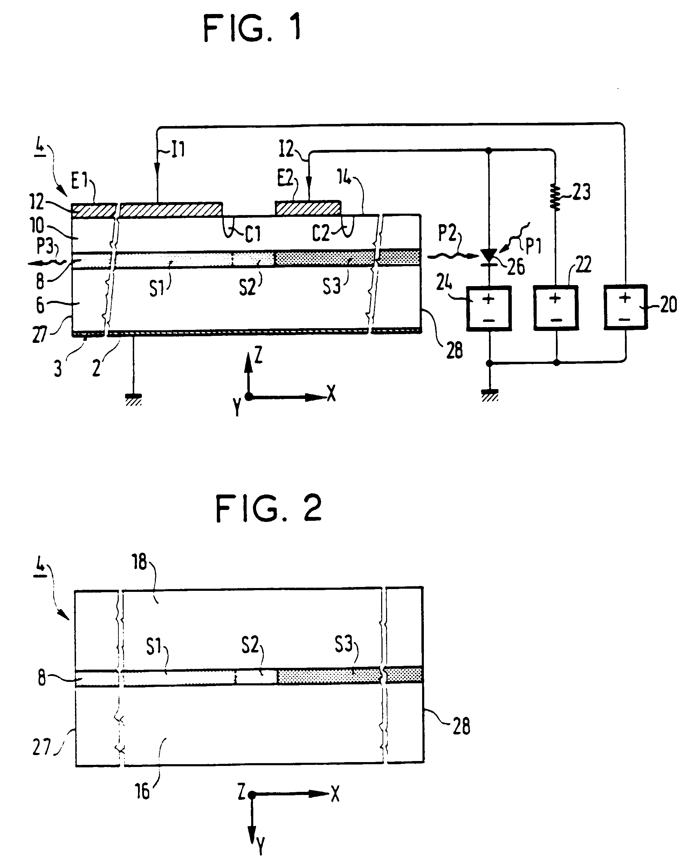

Selon ces dispositions communes le premier dispositif de traitement donné en exemple comporte les éléments suivants représentés à la Figure 1 :
- un récepteur de lumière 26 pour recevoir d'une part un signal d'entrée P1 de nature optique d'autre part un signal optique interne P2, et pour fournir, en réponse à l'ensemble de ces deux signaux, un signal électrique interne I2,
- et un émetteur de lumière 4 pour fournir, en réponse à ce signal électrique interne, d'une part ledit signal optique interne en constituant une boucle de rétroaction, d'autre part un signal de sortie P3 de nature optique.

Cette boucle a un gain de boucle qui est un gain différentiel de boucle ouverte et qui présente des variations en fonction des deux dits signaux optique et électrique internes. Ces variations font apparaître une valeur maximale de ce gain de boucle pour deux valeurs non nulles de ces deux signaux, respectivement.

Un moyen d'élévation de gain est inclus dans cette boucle pour élever au moins cette valeur maximale du gain de boucle et pour la rendre de préférence supérieure à 0,9.

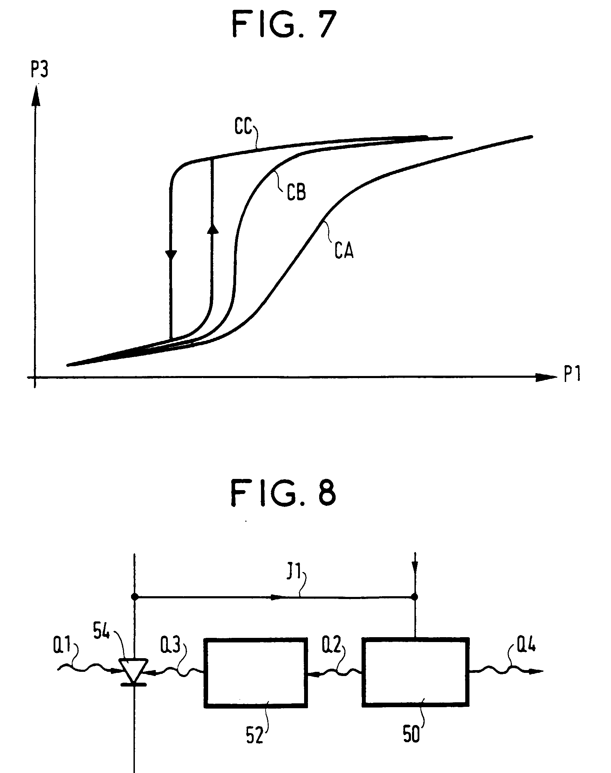

La présence d'une boucle de rétroaction présentant un gain qui s'approche ainsi de l'unité ou qui la dépasse permet de faire varier le gain différentiel du dispositif, c'est-à-dire le rapport de la variation du signal de sortie P3 à celle du signal d'entrée P1, dans une proportion beaucoup plus forte que celle dans laquelle varie le gain de boucle. La variation de la puissance du signal de sortie P3 d'un tel dispositif en fonction des variations du signal d'entrée P1 est illustrée sur la Figure 7 par trois courbes dites "caractéristiques" CA, CB et CC qui correspondent, respectivement, à des valeurs du gain de boucle G inférieure, égale et supérieure à l'unité.

Dans le cas d'un gain peu inférieur ou égal à un la courbe caractéristique du dispositif est en forme de S. Dans le cas d'un gain de boucle supérieur à un, elle présente un cycle d'hystérésis, c'est-à-dire une bistabilité.

De telles courbes caractéristiques peuvent notamment permettre de restituer la forme d'une impulsion initialement rectangulaire qui a été déformée au cours de sa transmission. Bien entendu un gain global du dispositif de traitement peut être choisi très supérieur au gain de boucle si on souhaite obtenir un signal de sortie de puissance sensiblement supérieure à celle du signal d'entrée.

En complément à ces dispositions communes, on peut, selon la présente invention, adopter diverses dispositions avantageuses qui vont maintenant être décrites de manière générale.

Selon une telle disposition avantageuse qui est adoptée dans les deux dispositifs donnés en exemples et qui va être décrite à l'aide de la Figure 1, le signal électrique interne I2 est appliqué sans amplification à l'émetteur de lumière 4, et ledit moyen d'élévation de gain est au moins associé à cet émetteur pour commander le signal optique interne P2 tel que reçu par le récepteur de lumière 26.

Selon une autre disposition avantageuse qui est adoptée dans le premier dispositif donné en exemple, ce moyen d'élévation de gain comporte un absorbeur saturable S2 dont l'absorbance est commandée par ledit signal électrique interne I2 et décroit lorsque ce signal croît, la variation de cette absorbance en fonction de ce signal provoquant une croissance du gain de boucle lorsque ce signal atteint en croissant une zone de non linéarité de ce dispositif.

Selon une autre disposition avantageuse cet absorbeur saturable S2 et un amplificateur de lumière S1 sont inclus dans une cavité optique résonnante 27, 28 pour former un oscillateur laser constituant ledit émetteur de lumière 4. Ces dispositions présentent l'avantage que l'intensité du signal électrique interne fourni par le récepteur de lumière peut être très petite. Cette petitesse facilite la réalisation du dispositif. D'autre part elle permet d'utiliser un récepteur 26 à réponse rapide tel qu'une photodiode rapide du type pin polarisée en inverse. L'emploi d'une telle polarisation de cette photodiode est rendu possible, sans créer un risque de détérioration de la plaquette 4, par le fait que le courant I2 est de sens direct. Cette polarisation est par exemple réalisée par une source de potentiel 24. Le courant I2 est constitué par la somme du courant traversant cette photodiode et d'un courant de prépolarisation fourni par une autre source de potentiel 22 à travers une résistance 23. Ces deux sources de potentiels et cette photodiode constituent ensemble la source de commande d'absorbance.

Cet absorbeur est par exemple l'absorbeur S2 de l'oscillateur laser précédemment décrit.

Selon une autre disposition avantageuse qui est déjà apparue ci-dessus à propos de cet oscillateur, ces absorbeur S2 et amplificateur de lumière S1 constituent deux sections longitudinalement successives d'un guide de lumière S1, S2, S3 formé dans une plaquette semiconductrice 4 qui constitue ledit émetteur de lumière et au sein de laquelle cet amplificateur reçoit un courant d'alimentation I1 fourni par une source d'alimentation 20 qui est au moins partiellement indépendante du signal optique interne P2.

Par ailleurs il peut être avantageux que la longueur d'onde d'émission, c'est-à-dire celle du signal de sortie P3, soit commandée. Ceci pourrait être par exemple réalisé à l'aide d'un réflecteur de Bragg distribué qui serait formé dans une section de commande de fréquence du guide de lumière et qui serait complété par une section d'accord de phase, les indices de réfraction de ces deux sections étant commandés comme connu par des courants électriques injectant des porteurs de charge dans ces sections.

La longueur d'onde d'émission peut par ailleurs être avantageusement différente de celle du signal d'entrée P1. Cette disposition réalise un découplage optique entre le laser constitué par la plaquette 4 et une source optique amont non représentée fournissant le signal d'entrée constitué par le faisceau P1. Ce découplage élimine tout effet perturbateur de rétroaction optique parasite sur cette source amont.

On va maintenant donner de manière plus particulière diverses indications sur les éléments précédemment mentionnés.

La plaquette 4 a été réalisée à partir dun substrat de phosphure d'indium InP dopé n par épitaxie en phase liquide. Les matériaux actif (sections S1 et S2) et passif (section S3) utilisés seront dits ci-après de type 1 et 2. Ce sont des alliages quaternaires non intentionnellement dopés. Ils sont constitués d'indium, de gallium, d'arsenic et de phosphore du type In₁₋ₓGaₓAs_{y}P_{1-y} et accordés en maille avec le substrat. Ces matériaux présentent, respectivement des bandes interdites correspondant à des longueurs d'onde 1 530nm et 1300 nm. La première de ces deux longueurs constitue ladite longueur d'onde d'émission. Les matériaux de confinement, c'est-à-dire ceux des couches de confinement, sont le substrat d'InP dopé n pour la couche de confinement inférieure 6 et une couche épitaxiée d'InP dopé p pour la couche de confinement supérieure 10. Une couche de contact épitaxiée n'est pas représentée. Son épaisseur est 200 nm. Elle est constituée d'un matériau de contact quaternaire de type 2 et fortement dopée p. Elle est présente sous les électrodes E1 et E2.

La plaquette 4 a été réalisée selon la filière technologique dite du phosphure d'indium, mais son principe de réalisation peut être transféré à tout système de matériaux semi-conducteurs tel celui de que la filière arséniure de gallium, GaAs. Les matériaux de type 1 et 2 peuvent également être remplacés par des structures plus complexes telles que des structures à multi-puits quantiques, à super réseaux, ou à un empilement quelconque de couches de matériaux différents, dopés ou non. Il suffit que la structure mise en place du matériau 1 présente un gain optique à la longueur d'onde d'émission désirée et que la structure mise en place du matériau de type 2 soit transparente pour cette même longueur d'onde.

Les matériaux actif et passif doivent être entourés de part et d'autre par des matériaux de confinement également transparents à la longueur d'onde d'émission, afin de constituer un guide d'onde monomode. Un matériau sera dit transparent si son absorption linéique est typiquement inférieure à 50 cm⁻¹ . Les différents éléments de la plaquette 4 réalisée peuvent être précisés comme suit :
- Amplificateur S1 et absorbeur S2 constitués de matériau de type 1, dit actif présentant un gain optique maximal à la longueur d'onde d'émission et non-intentionnellement dopé n à 10¹⁷ cm⁻³.
- Section passive S3 constituée de matériau de type 2, dit passif, transparent pour la longueur d'onde d'émission, présentant un gain optique maximal à la longueur d'onde de 1 300 nm, dopé n à 5.10¹⁷ cm⁻³.
- Couche de confinement supérieure 10 de type InP dopée p avec une concentration comprise entre 10¹⁷ et 2.10¹⁸cm⁻³, d'épaisseur typiquement supérieure à 1000 nm.
- Couche de confinement inférieure 6 de type InP, dopée n avec une concentration comprise entre 10¹⁷ et 5.10¹⁸ cm⁻³, d'épaisseur supérieure à 1000 nm.
- Absorbeur S2 non directement alimenté par l'électrode E1. Il présente une absorbance saturable à la longueur donde d'émission. Sa longueur typique peut varier entre 0,005 et 0,025 mm. Sa longueur réalisée est, par exemple, de 0,01 mm.
- La dimension de l'électrode E1 selon ladite direction longitudinale peut typiquement varier entre 0,1 et 0,6 mm, par exemple 0,4 mm.
- L'électrode de commande d'absorbance E2 est typiquement située au voisinage de la transition (à une distance inférieure à 0,01 mm) entre les matériaux actif et passif et donc de l'absorbeur saturable. Sa dimension selon la direction X peut varier entre 0,001 et 0,1 mm. Elle détermine directement la valeur du courant de commande I2. Il y a intérêt à rendre cette électrode la plus étroite possible, une valeur réalisée étant de 0,085 mm.
- Les canaux d'isolement C1 et C2 sont creusés dans le matériau de contact (non-représenté) et la couche de confinement supérieure 10 afin de déterminer les valeurs des résistances entre sections ou entre électrodes. Ces canaux peuvent typiquement avoir une largeur de 0,005 mm et une profondeur égale au 3/4 de l'épaisseur totale du matériau de contact et du matériau de confinement supérieur.
- La résistance électrique entre l'électrode d'alimentation E1 et l'absorbeur saturable S2 peut varier entre 100 ohms et 10 000 ohms. On a testé les valeurs 200 ohms et 1 400 ohms.
- La résistance électrique entre l'électrode de commande d'absorbance E2 et l'absorbeur saturable S2 a été testée avec une valeur de 20 ohms.

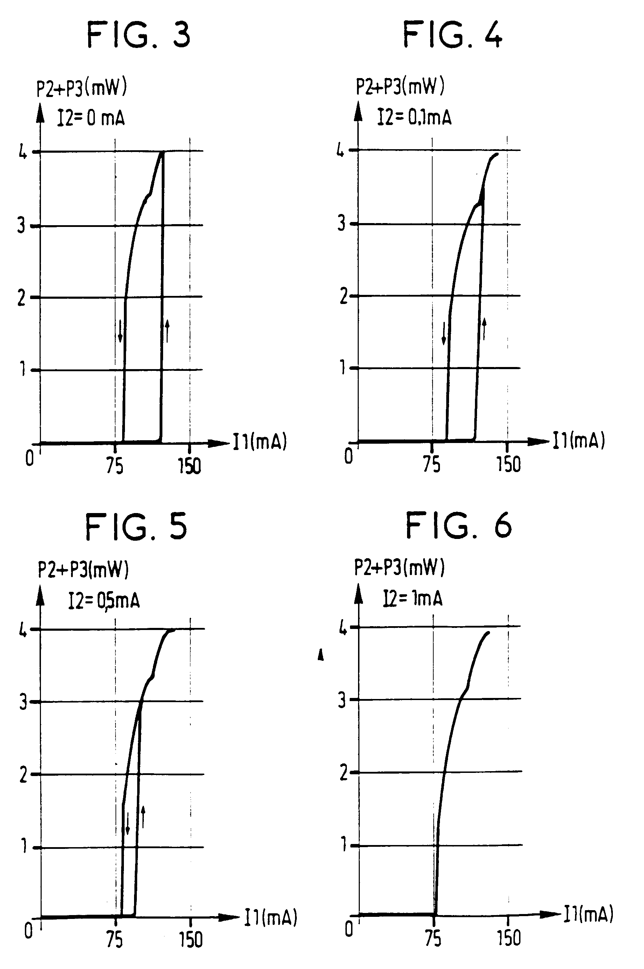

Les figures 3, 4, 5 et 6 représentent le comportement du laser réalisé décrit ci-dessus pour quatre valeurs du courant de commande I2 respectivement 0-0,1-0,5 et 1mA. Elles montrent le cycle d'hystérésis de la puissance optique émise (en ordonnée) en fonction de l'intensité du courant (en abscisse) injecté dans le laser à travers l'électrode d'alimentation E1.

Il est remarquable qu'une intensité du courant I2 aussi faible que 0,1 mA permette de commander l'absorbance de l'absorbeur saturable. Une fermeture complète du cycle d'hystérésis est obtenue pour une variation de I2 inférieure à 1mA. Une augmentation de I2 réduit principalement la valeur du courant I1 provoquant l'émission lumineuse, mais il est important de constater que la valeur du courant I1 provoquant l'extinction est également réduite.

Un intérêt important de la présente invention réside dans le fait que l'on peut commander la largeur du cycle d'hystérésis d'un laser à semiconducteur bistable par des courants de commande très faibles typiquement inférieurs au mA et qu'en plus cette commande se fait avec une polarisation directe de la jonction semiconductrice qui reçoit ce courant au sein de ce laser. Ceci permet de réaliser plus facilement un dispositif de traitement de signal dans lequel le signal électrique interne I2 est fourni par une photodiode polarisée en inverse telle que 26.

On va maintenant décrire une disposition alternative avantageuse qui est adoptée dans le deuxième dispositif donné en exemple et qui va être décrite par référence à la Figure 8.

Selon cette disposition, ledit émetteur de lumière est constitué par un oscillateur laser 50 qui est alimenté par ledit signal électrique interne, constitué ici par un signal J1, et qui fournit ledit signal optique interne, constitué ici par une signal Q2, avec un rendement quantique toujours inférieur à ladite valeur maximale du gain de boucle. Ledit moyen d'élévation de gain est alors constitué par un amplificateur de lumière. Il constitue un amplificateur de boucle 52 externe à l'oscillateur laser 50. Il reçoit le signal optique interne en sortie de cet oscillateur laser, l'amplifie, et transmet en réponse un signal optique interne amplifié Q3 audit récepteur de lumière qui est ici un récepteur 54.

Lesdits signaux d'entrée et de sortie de ce dispositif sont représentés en Q1 et Q4, respectivement.

Dans le cadre de cette disposition l'oscillateur laser peut être du type à rétroaction distribuée appelé internationalement "DFB" et il peut être intégré au sein d'une plaquette semiconductrice avec l'amplificateur de boucle et, éventuellement, avec le récepteur de lumière.

## Revendications

1. Dispositif à rétroaction positive pour le traitement d'un signal optique, ce dispositif comportant :
- un récepteur de lumière (26) pour recevoir d'une part un signal d'entrée (P1) de nature optique d'autre part un signal optique interne (P2), et pour fournir, en réponse à l'ensemble de ces deux signaux, un signal électrique interne (I2),
- et un émetteur de lumière (4) pour fournir, en réponse audit signal électrique interne, d'une part ledit signal optique interne en constituant une boucle de rétroaction, d'autre part un signal de sortie (P3) de nature optique, ces signaux optique interne (P2) et de sortie (P3) étant constitués d'une lumière d'émission qui présente une longueur d'onde d'émission propre à cet émetteur de lumière, cette boucle ayant un gain de boucle qui est un gain différentiel de boucle ouverte et qui présente des variations en fonction des deux dits signaux optique et électrique internes, ces variations faisant apparaître une valeur maximale de ce gain de boucle pour un ensemble de deux valeurs non nulles de ces deux signaux, respectivement,
- un moyen d'élévation de gain étant inclus dans cette boucle pour élever au moins cette valeur maximale du gain de boucle,
- ce dispositif étant caractérisé par le fait que ledit signal électrique interne (I2) est appliqué sans amplification audit émetteur de lumière (4), ledit moyen d'élévation de gain (S1, S2) étant au moins associé audit émetteur de lumière (4) pour fournir un dit signal amplifié constitué par ledit signal optique interne (P2) tel que reçu par ledit récepteur de lumière (26).

2. Dispositif selon la revendication 1, dans lequel ladite valeur maximale du gain de boucle est supérieure à 0,9.

3. Dispositif selon la revendication 1, caractérisé par le fait que ledit moyen d'élévation de gain (S1, S2) comporte un absorbeur saturable (S2) apte à absorber une énergie lumineuse à l'instant où il reçoit une telle énergie, cet absorbeur absorbant cette énergie seulement dans la mesure où l'énergie lumineuse qu'il a absorbée et accumulée pendant une période de conservation d'énergie est inférieure à une absorbance de cet absorbeur, cette période de conservation d'énergie précédant et incluant cet instant et ayant une durée limitée, cette absorbance étant commandée par ledit signal électrique interne (I2) et décroissant lorsque ce signal croît, la variation de cette absorbance en fonction de ce signal provoquant une croissance dudit gain de boucle lorsque ce signal atteint en croissant une zone de non linéarité de ce dispositif.

4. Dispositif selon la revendication 3, caractérisé par le fait que ledit absorbeur saturable (S2) et un amplificateur de lumière (S1), sont inclus dans une cavité optique résonnante (27, 28) pour former un oscillateur laser constituant ledit émetteur de lumière (4).

5. Dispositif selon la revendication 4, caractérisé par le fait que lesdits absorbeur (S2) et amplificateur de lumière (S1) constituent deux sections longitudinalement successives d'un guide de lumière (S1, S2, S3) formé dans une plaquette semiconductrice (4) qui constitue ledit émetteur de lumière et au sein de laquelle cet amplificateur reçoit un courant d'alimentation (I1) fourni par une source d'alimentation (20) qui est au moins partiellement indépendante dudit signal optique interne (P2).

6. Dispositif selon la revendication 1, caractérisé par le fait que ledit émetteur de lumière est constitué par un oscillateur laser (50) alimenté par ledit signal électrique interne (J1), cet oscillateur laser fournissant ledit signal optique interne (Q2) avec un rendement quantique toujours inférieur à ladite valeur maximale du gain de boucle, ledit moyen d'élévation de gain étant constitué par un amplificateur de lumière qui constitue un amplificateur de boucle (52) et qui est externe à cet oscillateur laser, cet amplificateur recevant ce signal optique interne en sortie de cet oscillateur laser et transmettant en réponse un signal optique interne amplifié (Q3) audit récepteur de lumière.

7. Dispositif selon la revendication 1, caractérisé par le fait que ledit récepteur de lumière (26) est une photodiode rapide du type p i n polarisée en inverse.

8. Dispositif selon la revendication 1, caractérisé par le fait que ladite longueur d'onde d'émission est commandée.

9. Dispositif selon la revendication 1, caractérisé par le fait que ladite longueur d'onde d'émission est différente de la longueur d'onde dudit signal d'entrée (P1).

## Patentansprüche

1. Vorrichtung mit positiver Rückkopplung für die Verarbeitung eines optischen Signals,
- mit einem Lichtempfänger (26), der einerseits ein optisches Eingangssignal (P1) und andererseits ein internes optisches Signal (P2) empfängt und als Antwort auf diese beiden Signale ein internes elektrisches Signal (I2) liefert,
- und mit einem Lichtemitter (4), der als Antwort auf das interne elektrische Signal einerseits das interne optische Signal unter Bildung einer Rückkopplungsschleife und andererseits ein optisches Ausgangssignal (P3) liefert, wobei das interne optische Signal (P2) und das optische Ausgangssignal (P3) von Lichtstrahlen gebildet werden, die eine für diesen Lichtemitter typische Emissionswellenlänge besitzen und wobei die Schleife einen Schleifenverstärkungsgrad aufweist, der ein differentialer Verstärkungsgrad bei offener Schleife ist und Veränderungen abhängig von den beiden internen Signalen, dem optischen und dem elektrischen, aufweist, die einen Maximalwert des Schleifenverstärkungsgrads für eine Kombination von Werten dieser beiden Signale ungleich Null ergeben,
- wobei ein Mittel zur Erhöhung des Verstärkungsgrads in der Schleife enthalten ist, um zumindest den Maximalwert des Schleifenverstärkungsgrads zu erhöhen,
dadurch gekennzeichnet, daß das interne elektrische Signal (I2) ohne Verstärkung an den Lichtemitter (4) angelegt ist und daß das Mittel zur Erhöhung des Schleifenverstärkungsgrads (S1, S2) zumindest dem Lichtemitter (4) zugeordnet ist, um ein von dem internen optischen Signal gebildetes verstärktes Signal (P2) zu liefern, das vom Lichtempfänger (26) empfangen wird.

2. Vorrichtung nach Anspruch 1, in der der Maximalwert der Schleifenverstärkung größer als 0,9 ist.

3. Vorrichtung nach Anspruch 1, dadurch gekennzeichnet, daß das Mittel zur Erhöhung des Verstärkungsgrads (S1, S2) einen sättigungsfähigen Absorber (S2) enthält, der eine Lichtenergie in dem Augenblick absorbieren kann, in dem er diese Energie empfängt, wobei dieser Absorber die Energie nur dann absorbiert, wenn die Lichtenergie, die er während einer Energieerhaltungsperiode absorbiert und akkumuliert hatte, unter einem Absorptionsschwellwert liegt, wobei die Energieerhaltungsperiode vor diesem Zeitpunkt liegt und diesen einschließt und eine beschränkte Dauer besitzt, wobei die Absorptionsfähigkeit durch das interne elektrische Signal (I2) gesteuert wird und abnimmt, wenn dieses Signal zunimmt, und wobei die Veränderung dieser Absorptionsfähigkeit abhängig von diesem Signal einen Anstieg des Schleifenverstärkungsgrads hervorruft, wenn dieses Signal bis zu einer Nichtlinearitätszone dieser Vorrichtung ansteigt.

4. Vorrichtung nach Anspruch 3, dadurch gekennzeichnet, daß der sättigungsfähige Absorber (S2) und ein Lichtverstärker (S1) in einem optischen Resonanzhohlraum (27, 28) enthalten sind, um einen Laseroszillator zu bilden, der den Lichtemitter (4) darstellt.

5. Vorrichtung nach Anspruch 4, dadurch gekennzeichnet, daß der Absorber (S2) und der Lichtverstärker (S1) zwei aufeinanderfolgende Längsabschnitte eines Lichtleiters (S1, S2, S3) darstellen, der in einem Halbleiterplättchen (4) ausgebildet ist, das den Lichtemitter bildet und in dem dieser Verstärker einen Speisestrom (I1) von einer Speisestromquelle (20) empfängt, die zumindest teilweise von dem internen optischen Signal (P2) unabhängig ist.

6. Vorrichtung nach Anspruch 1, dadurch gekennzeichnet, daß der Lichtemitter aus einem Laseroszillator (50) besteht, der von dem internen elektrischen Signal (J1) gespeist ist und das interne optische Signal (Q2) mit einem Quantenwirkungsgrad stets unterhalb des maximalen Schleifenverstärkungsgrads liefert, wobei das Mittel zur Erhöhung des Verstärkungsgrads von einem Lichtverstärker gebildet wird, der einen Schleifenverstärker (52) bildet und außerhalb dieses Laseroszillators liegt sowie das interne optische Signal am Ausgang des Laseroszillators empfängt und daraus ein internes verstärktes optisches Signal (Q3) ableitet, das er an den Lichtempfänger liefert.

7. Vorrichtung nach Anspruch 1, dadurch gekennzeichnet, daß der Lichtempfänger (26) eine schnelle Fotodiode vom Typ PIN ist, die in Sperrichtung vorgespannt ist.

8. Vorrichtung nach Anspruch 1, dadurch gekennzeichnet, daß die Sendewellenlänge gesteuert wird.

9. Vorrichtung nach Anspruch 1, dadurch gekennzeichnet, daß sich die Sendewellenlänge von der Wellenlänge des Eingangssignals (P1) unterscheidet.

## Claims

1. A positive feedback device for treating an optical signal, the device comprising:
a light receiver (26) for receiving firstly an input signal (P1) that is optical and secondly an internal optical signal (P2), and for supplying an internal electrical signal (I2) in response to the combination of these two signals,
and a light emitter (4) responsive to said internal electrical signal to supply firstly said internal optical signal to form a feedback loop and secondly an output signal (P3) that is optical, these internal and output optical signals (P2 and P3) each being constituted by emission light with an emission wavelength of this light emitter, the loop having a loop gain which is an open loop differential gain and which varies as a function of said two optical and electrical internal signals, this variation exhibiting a maximum value of the loop gain for a combination of two respective non-zero values of these two signals,
means for increasing the gain being included in this loop to increase at least said maximum value of the loop gain,
the device being characterized in that said internal electrical signal (I2) is applied without amplification to said light emitter (4), said means for increasing the gain (S1, S2) being associated at least with said light emitter (4) to provide an amplified signal forming said internal optical signal (P2) such as is received by said light receiver (26).

2. A device according to claim 1, in which said maximum value of the loop gain is greater than 0.9.

3. A device according to claim 1, characterized in that said means for increasing the gain (S1, S2) comprise a saturable absorber (S2) adapted to absorb light energy at the instant it receives such energy, this absorber absorbing the energy only while the amount of light energy which it has absorbed and accumulated during an energy storage interval is less than an absorbance of the absorber, the energy storage interval preceding and including the current instant and having a limited duration, the absorbance being controlled by the internal electrical signal (I2) and decreasing as this signal increases, and the variation in the absorbance as a function of this signal causing an increase in the loop gain when the signal increases to a non-linear region of the device.

4. A device according to claim 3, characterized in that said saturable absorber (S2) and a light amplifier (S1) are included in a resonant optical cavity (27, 28) to form a laser oscillator constituting said light emitter (4).

5. A device according to claim 4, characterized in that said absorber (S2) and light amplifier (S1) form two longitudinally successive sections of a light guide (S1, S2, S3) formed in a semiconductor wafer (4) which forms said light emitter and within which the amplifier receives a power supply current (I1) supplied by a source of power supply (20) which is at least partially independent of said internal optical signal (P2).

6. A device according to claim 1, characterized in that said light emitter is formed by a laser oscillator (50) powered by said internal electrical signal (J1), this laser oscillator supplying said internal optical signal (Q2) at an output level always below said maximum value of the loop gain, said means for increasing the gain being formed by a light amplifier which constitutes a feedback amplifier (52) and which is external to the laser oscillator, the amplifier receiving the internal optical signal at the output of the laser oscillator and, in response thereto, transmitting an amplified internal optical signal (Q3) to said light receiver.

7. A device according to claim 1, characterized in that said light receiver (26) is a reverse biased fast-acting photodiode of PIN type.

8. A device according to claim 1, characterized in that said emission wavelength is controlled.

9. A device according to claim 1, characterized in that said emission wavelength is different from the wavelength of said input signal (P1).
